# DEMANDE DE BREVET EUROPEEN

(11) **EP 4 215 648 A1**
(43) Date de publication de la demande: **26.07.2023**
(21) Numéro de dépôt: 22305078.2
(22) Date de dépôt: 25.01.2022
(51) Int. Cl.: C30B 1/12, C30B 29/04

(54) **PROCÉDÉ POUR PRODUIRE DU DIAMANT DE SYNTHÈSE**

(71) Demandeur: Aithra, 31400 Toulouse (FR)
(72) Inventeur: NEUVILLE, Cédric, 31400 TOULOUSE (FR); BERTUCCHI, Marine, 31400 TOULOUSE (FR)
(74) Mandataire: Ipside

(57) **Abrégé**

L'invention concerne un procédé pour produire du diamant à partir d'un échantillon comportant un matériau carboné, comportant la génération et l'émission de N ondes acoustiques, N étant un nombre supérieur ou égal à 2, lesdites N ondes acoustiques émises étant focalisées en une zone focale dans l'échantillon (50), chacune des N ondes acoustiques étant émise avec une intensité acoustique minimale pour générer ensemble au niveau de la zone focale une intensité acoustique au moins égale à une intensité acoustique minimale suffisante pour réaliser un changement de phase du matériau carboné en diamant.

## Description

### Domaine technique de l'invention

La présente invention s'inscrit dans le domaine de la production de diamant. L'invention concerne un procédé de production de diamant de synthèse ainsi qu'un dispositif pour la mise en œuvre de ce procédé.

### Technique antérieure

Le diamant de synthèse est de plus en plus utilisé dans l'industrie, notamment pour ses propriétés électroniques, mécaniques, optiques, thermiques ou encore chimiques.

Pour produire un diamant de synthèse, plusieurs technologies existent.

Parmi ces technologies, on peut citer la technologie Haute Pression, Haute Température, connue sous l'acronyme HPHT (« High Pressure High Temperature », dans la littérature anglo-saxonne). Cette technologie consiste à placer un échantillon de carbone, par exemple du graphite, dans une enceinte et à le soumettre à une température élevée, de l'ordre de 1500°C, et à une pression élevée, de l'ordre de 15 GPa. L'ajout d'un catalyseur à l'échantillon, par exemple un métal de transition comme le nickel ou le cobalt, permet d'abaisser la température à 1000°C et la pression à 6 GPa.

Une autre technologie consiste à réaliser un dépôt chimique en phase vapeur, connue sous l'acronyme CVD (« Chemical Vapor Deposition », dans la littérature anglo-saxonne). Un échantillon en diamant est placé dans une enceinte sous vide. Un gaz, avec hydrogène, est introduit dans l'enceinte. L'ensemble est ensuite ionisé à l'aide d'une décharge microondes, créant un plasma. Les espèces issues du plasma s'adsorbent petit à petit sur le substrat et forment l'objet.

Pour ces deux premières technologies, les principaux inconvénients sont :
- la difficulté, voire l'impossibilité, à contrôler finement la localisation spatiale où les conditions sont réunies pour permettre la formation du diamant ;
- la limitation de la direction de croissance du diamant : pour la technologie HPHT, les directions sont imposées par le schéma de compression ; pour la technologie CVD, la direction est perpendiculaire au substrat.

Une autre technologie repose sur l'utilisation d'ondes de choc. Les ondes de choc sont par exemple générées par projection d'une feuille métallique, sur un échantillon en graphite. On parle généralement dans la littérature d'ondes de choc par explosion. Les ondes de choc peuvent également être générées par ablation laser.

Cette technologie présente de nombreux inconvénients, notamment la destruction partielle de l'échantillon en graphite pour produire ces chocs et la durée très limitée dans le temps de ces chocs, de l'ordre de la microseconde. Les diamants obtenus sont uniquement sous la forme de nanocristaux ou de microcristaux.

### Présentation de l'invention

La présente invention vise à remédier aux inconvénients des solutions proposées par l'art antérieur, notamment à ceux exposés ci-avant.

A cet effet, il est proposé par la présente invention un procédé pour produire du diamant à partir d'un échantillon comportant un matériau carboné, ledit procédé comportant la génération et l'émission de N ondes acoustiques, N étant un nombre supérieur ou égal à 2, lesdites N ondes acoustiques émises étant focalisées en une zone focale dans l'échantillon. Chacune des N ondes acoustiques est émise avec une intensité acoustique minimale pour générer, ensemble, au niveau de la zone focale dans l'échantillon une intensité acoustique au moins égale à une intensité acoustique minimale suffisante pour réaliser un changement de phase du matériau carboné en diamant.

Pour réaliser un changement de phase du matériau carboné en diamant, au niveau de la zone focale, l'intensité acoustique doit être suffisante pour que :
- la pression acoustique atteinte dépasse une pression minimale suffisante rendant le diamant plus stable que le matériau carboné,
- l'énergie cinétique des atomes soit suffisante pour rompre la métastabilité dudit matériau carboné pendant la durée de l'émission des ondes acoustiques.

Lorsque l'intensité acoustique générée au niveau de la zone focale est au moins égale à l'intensité acoustique minimale suffisante, la durée de l'émission de l'intensité acoustique conditionne ensuite le pourcentage de conversion du matériau carboné en diamant dans cette zone focale. En d'autres termes, pour une intensité acoustique émise donnée au niveau de la zone focale, plus la durée de l'émission de l'intensité acoustique est importante, plus le pourcentage de conversion du matériau carboné en diamant augmente dans la zone focale. De plus, pour un pourcentage souhaité de conversion du matériau carboné en diamant, plus l'intensité acoustique émise est importante, plus la durée de l'émission de l'intensité acoustique au niveau de la zone focale est réduite.

Ainsi, selon l'intensité acoustique générée au niveau de la zone focale, les N ondes acoustiques sont préférentiellement émises pendant au moins une durée minimum permettant un pourcentage prédéfini souhaité de conversion du matériau carboné en diamant dans la zone focale.

Le procédé selon l'invention permet ainsi avantageusement de créer un germe de diamant ou d'agrandir un germe de diamant préexistant dans l'échantillon, au niveau de la zone focale.

Le procédé permet avantageusement de contrôler finement la localisation spatiale où les conditions sont réunies pour permettre la formation du diamant, contrairement aux technologies existantes HPHT et CVD.

Le procédé permet également avantageusement de produire un germe de diamant ou d'agrandir un germe de diamant préexistant, sans détruire l'échantillon, contrairement aux technologies existantes d'ondes de choc.

Selon des modes de mise en œuvre particuliers, l'invention répond en outre aux caractéristiques suivantes, mises en œuvre séparément ou en chacune de leurs combinaisons techniquement opérantes.

Dans des modes de mises en œuvre particuliers de l'invention, le procédé comporte, pendant l'émission des N ondes acoustiques, le déplacement de la zone focale dans l'échantillon (50). Les N ondes acoustiques sont préférentiellement émises pendant une durée supérieure à la durée minimum pour l'obtention du pourcentage prédéfini souhaité de conversion du matériau carboné en diamant dans la zone focale.

Un tel déplacement de la zone focale dans l'échantillon permet avantageusement de faire croitre le germe de diamant jusqu'à l'obtention d'une dimension et d'une forme souhaitée pour le diamant. Le sens du déplacement de la zone focale dans l'échantillon permet de diriger le sens de croissance du diamant pour obtenir la forme souhaitée.

L'invention est également relative à un dispositif pour la mise en œuvre du procédé conforme à au moins l'un de ses modes de mise en œuvre, ledit dispositif comportant :
- N générateurs d'ondes acoustiques, configurés pour générer chacun une onde acoustique, N étant un nombre supérieur ou égal à 2,
- un système de focalisation des N ondes acoustiques en une zone focale dans l'échantillon.

Chaque générateur d'ondes acoustiques du dispositif est avantageusement configuré pour émettre une onde acoustique, de fréquence f, de préférence comprise entre 1 MHz et 100 MHz.

Dans un exemple préféré de réalisation, tous les générateurs d'ondes acoustiques du dispositif émettent à une même fréquence.

Le système de focalisation est agencé et dimensionné pour recevoir l'ensemble des ondes acoustiques émises par les générateurs d'ondes acoustiques.

Selon des modes de réalisation particuliers, l'invention répond en outre aux caractéristiques suivantes, mises en œuvre séparément ou en chacune de leurs combinaisons techniquement opérantes.

Dans des modes de réalisation particuliers, chaque générateur d'ondes acoustiques est un actionneur piézoélectrique.

Dans des modes de réalisation particuliers, pour faire croitre le diamant, le dispositif comporte un organe de déplacement de la zone focale dans l'échantillon.

Dans des exemples de réalisation d'organe de déplacement, ledit organe de déplacement de la zone focale dans l'échantillon est un organe de déplacement du système de focalisation des ondes acoustiques et/ou un organe de déplacement de l'échantillon et/ou un organe de déplacement des générateurs d'ondes acoustiques et/ou un organe de déphasage des générateurs d'ondes acoustiques.

### Brève description des figures

L'invention sera mieux comprise à la lecture de la description suivante, donnée à titre d'exemple nullement limitatif, et faite en se référant aux figures suivantes :
Figure 1 représente une vue en perspective d'un dispositif adapté au procédé de production du diamant selon l'invention ;
Figure 2 représente une vue en perspective d'une moitié du dispositif de la figure 1 ;
Figure 3 représente une section transversale du dispositif de la figure 2 ;
Figure 4 représente un agrandissement de la zone III de la figure 3, illustrant un exemple de réalisation d'un actionneur piézoélectrique,
Figure 5 représente un graphique illustrant la durée nécessaire d'émission d'une onde acoustique en fonction de l'intensité de ladite onde acoustique pour recréer les conditions suffisantes pour parvenir à un changement de phase de 99% d'un échantillon de graphite en diamant, pour la technologie de l'onde de choc par explosion.

Dans ces figures, des références numériques identiques d'une figure à l'autre désignent des éléments identiques ou analogues. Par ailleurs, pour des raisons de clarté, les dessins ne sont pas à l'échelle, sauf mention contraire.

### Description des modes de réalisation

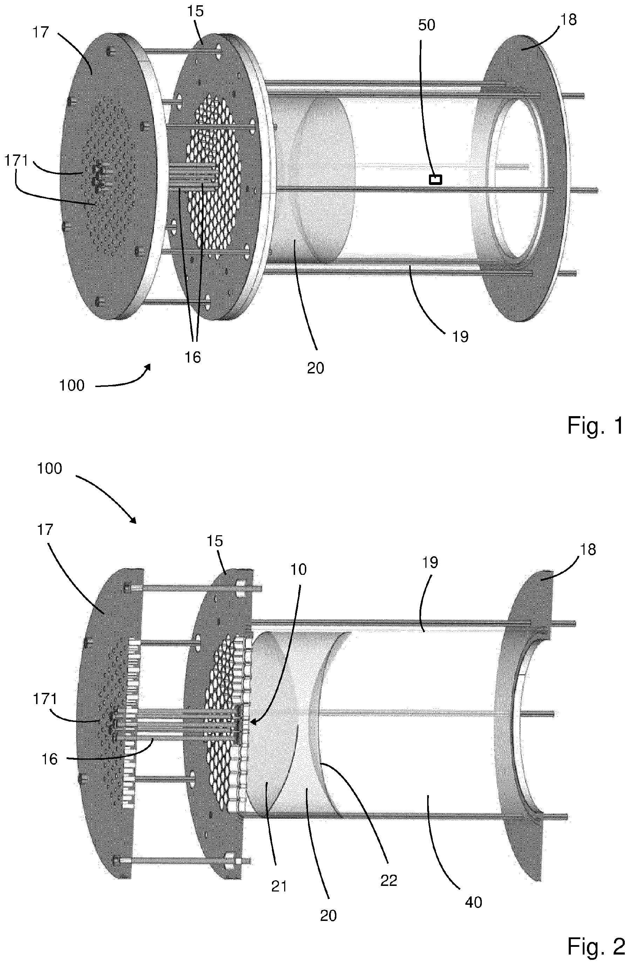

Les figures 1 à 4 illustrent les éléments constitutifs d'un exemple de dispositif 100 adapté à réaliser un procédé d'obtention d'un diamant à partir d'un échantillon comportant un matériau carboné, procédé objet de l'invention.

Dans la présente invention, le terme « matériau carboné » signifie un matériau constitué de formes allotropiques du carbone. De préférence, le matériau carboné comprend au moins 90 % en masse environ de carbone, et encore plus de préférence au moins 99,99 % en masse environ de carbone, par rapport à la masse totale dudit matériau carboné.

De préférence, le matériau carboné est choisi parmi le carbone amorphe, le carbone vitreux, le graphite, le graphène, les fullerènes, les nanotubes de carbone, le noir de carbone, ou leurs mélanges.

De préférence, le matériau carboné choisi n'est pas du diamant. Cependant, l'échantillon 50 peut comporter un germe de diamant et un matériau carboné autre que du diamant.

Le dispositif 100 comporte, comme illustré sur les figures 1 à 3 :
- N générateurs 10 d'ondes acoustiques, N étant un nombre entier supérieur ou égal à 2,
- un système de focalisation 20 desdites ondes acoustiques en une zone focale dans l'échantillon 50.

Un premier milieu 30 sépare les générateurs 10 d'ondes acoustiques du système de focalisation 20.

L'échantillon 50, situé en aval du système de focalisation 20, est disposé dans un second milieu 40. L'échantillon 50 est maintenu en position dans le second milieu 40. L'échantillon 50 comporte le matériau carboné, de préférence sous forme de poudre. Un récipient, placé dans le second milieu, permet par exemple de contenir l'échantillon.

Chaque générateur 10 d'ondes acoustiques du dispositif 100 est configuré pour générer et émettre une onde acoustique, de fréquence f, de préférence comprise entre 1 MHz et 100 MHz.

Dans un exemple préféré de réalisation, tous les générateurs 10 d'ondes acoustiques du dispositif 100 émettent à une même fréquence.

De préférence, les ondes acoustiques émises par les générateurs 10 sont synchrones.

Dans un autre exemple non limitatif de réalisation, une partie des générateurs 10 d'ondes acoustiques du dispositif 100, par exemple la moitié, émettent à une même fréquence fi et les autres générateurs 10 d'ondes acoustiques du dispositif 100 émettent à une même fréquence f₂, différente de fi.

De préférence, les générateurs 10 d'ondes acoustiques sont similaires entre eux. Dans un exemple préféré de réalisation, les générateurs 10 d'ondes acoustiques sont des actionneurs piézoélectriques. Un actionneur piézoélectrique convertit un signal électrique en un signal acoustique, d'intensité acoustique donnée.

Dans une forme préférée de réalisation d'un actionneur piézoélectrique, ledit actionneur piézoélectrique comporte un empilement successif de couches :
- au moins une couche 11 de désadaptation d'impédance,
- au moins un élément piézoélectrique 12,
- au moins une couche 13 d'adaptation d'impédance,
- une lentille de collimation 14.

Le au moins un élément piézoélectrique 12 est ainsi intercalé entre la au moins une couche 11 de désadaptation d'impédance et la au moins une couche 13 d'adaptation d'impédance. La au moins une couche 13 d'adaptation d'impédance est, quant à elle, intercalée entre le au moins un élément piézoélectrique 12 et la lentille de collimation 14.

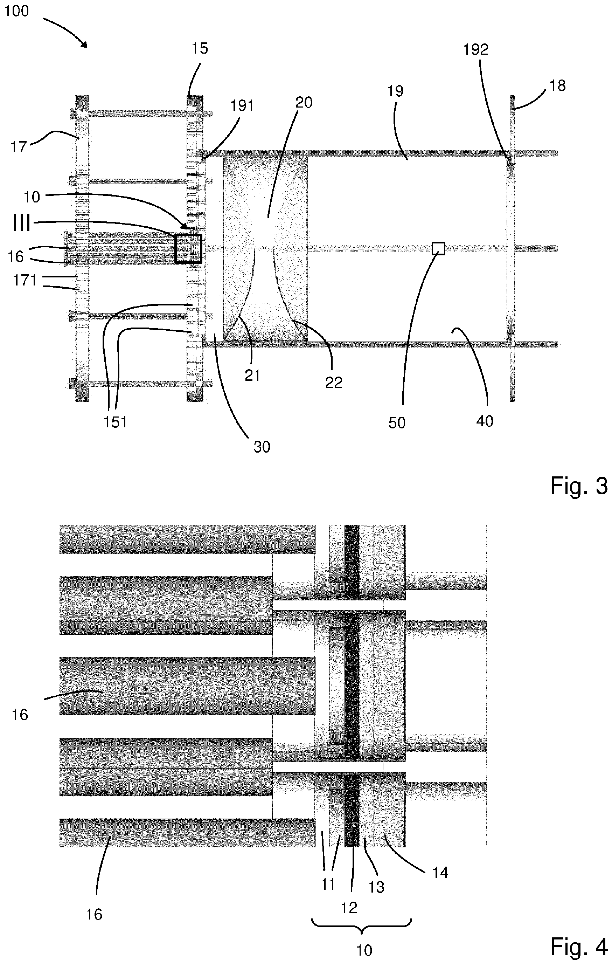

Dans l'exemple non limitatif illustré sur la figure 4, l'actionneur piézoélectrique 10 comporte deux couches 11 de désadaptation d'impédance, un élément piézoélectrique 12, une couche 13 d'adaptation d'impédance et une lentille de collimation 14.

La fréquence du signal électrique appliqué aux bornes du au moins un élément piézoélectrique 12 détermine la fréquence de l'onde acoustique générée. Cette fréquence peut par exemple correspondre à la fréquence de résonance du au moins un élément piézoélectrique 12 pour maximiser le taux de conversion du signal électrique en onde acoustique.

La au moins une couche 13 d'adaptation d'impédance est préférentiellement configurée pour maximiser la transmission de l'onde acoustique du au moins un élément piézoélectrique 12 vers la lentille de collimation 14.

La au moins une couche 11 de désadaptation d'impédance est préférentiellement configurée pour minimiser la transmission de l'onde acoustique hors du dispositif 100.

La lentille de collimation 14 est adaptée à la géométrie du front d'onde de l'onde acoustique. La lentille de collimation 14 est configurée pour collimater l'onde acoustique de sorte que l'onde acoustique, en sortie de l'actionneur piézoélectrique 10, se propage avec une orientation définie, dirigée vers le système de focalisation 20 du dispositif 100 dans le cas présent.

Les actionneurs piézoélectriques 10 sont préférentiellement disposés et maintenus fixement dans une pièce, dénommée barillet 15.

Ledit barillet comporte une pluralité d'orifices 151 destinés à recevoir chacun un actionneur piézoélectrique. Lesdits orifices sont traversants dans l'épaisseur du barillet.

Chaque actionneur piézoélectrique 10 est disposé dans un orifice 151 du barillet 15 de sorte que la lentille de collimation 14 est en vis-à-vis du système de focalisation 20.

Lesdits orifices du barillet 15 sont préférentiellement parallèles les uns aux autres. Les actionneurs piézoélectriques 10 étant disposés parallèlement les uns aux autres, les directions de propagation des ondes acoustiques collimatées en sortie des actionneurs piézoélectriques sont parallèles entre elles.

Lesdits orifices sont préférentiellement agencés dans le barillet 15 de sorte que les actionneurs piézoélectriques 10 sont disposés de manière équidistante les uns par rapport aux autres.

Les éléments constitutifs des actionneurs piézoélectriques 10 sont par exemple de forme cylindrique. Les orifices 151 du barillet 15 sont de forme cylindrique. Le diamètre desdits orifices du barillet est par exemple réduit à l'extrémité située du côté des lentilles de collimation 14 des actionneurs piézoélectriques 10 pour permettre auxdits actionneurs piézoélectriques d'y venir en appui.

Préférentiellement, un boulon de précontrainte 16 est configuré pour maintenir et comprimer un actionneur piézoélectrique 10 dans un orifice 151 du barillet 15. Une telle compression sur l'actionneur piézoélectrique permet avantageusement de maximiser le taux de conversion de l'énergie électrique en énergie acoustique. Chaque boulon de précontrainte 16 prend préférentiellement appui sur la couche 11 de désadaptation d'impédance.

Le dispositif 100 comporte autant de boulons de précontrainte 16 que d'actionneurs piézoélectriques 10.

Le dispositif 100 comporte de préférence une pièce, dénommée capot 17, fixement solidaire du barillet 15. Ledit capot comporte des orifices 171 taraudés dans lesquels se vissent les boulons de précontrainte 16.

Le dispositif 100 comporte de préférence une unité de gestion (non représentée sur les figures) des générateurs 10 d'ondes acoustiques.

Le dispositif, de préférence l'unité de gestion, est configuré pour contrôler la durée de l'émission des N ondes acoustiques par les générateurs 10 d'ondes acoustiques. Dans un exemple de réalisation, l'unité de gestion comporte une source d'alimentation et une unité de synchronisation.

Ladite source d'alimentation est configurée pour alimenter électriquement chacun des générateurs 10 d'ondes acoustiques, sous la forme d'un signal continu. Ladite unité de synchronisation est configurée pour piloter les générateurs 10 d'ondes acoustiques de manière synchrone.

Dans un exemple non limitatif de réalisation, lorsque les générateurs 10 d'ondes acoustiques sont des actionneurs piézoélectriques, l'unité de gestion comporte :
- une source d'alimentation configurée pour fournir la puissance nécessaire à chacun des actionneurs piézoélectriques, sous forme d'un signal continu ;
- une unité de synchronisation comportant :
   ∘ une première horloge, dite primaire, pour piloter les actionneurs piézoélectriques à partir d'une même et unique référence temporelle ;
   ∘ des horloges en cascade pour commander les circuits de puissance de chacun des actionneurs piézoélectriques avec des signaux en phase ;
   ∘ des circuits de puissance constitués de demi-pont en H pour charger et décharger les actionneurs piézoélectriques.

Comme décrit précédemment, le dispositif 100 comporte en outre un système de focalisation 20.

Un tel système de focalisation 20 est configuré pour recevoir et focaliser les N ondes acoustiques, émises par les N générateurs 10 d'ondes acoustiques, en une zone focale dans l'échantillon 50.

Par zone focale, on entend une région de dimension réduite, où toutes les ondes acoustiques vont converger.

La zone focale est préférentiellement de dimension inférieure à celle de l'échantillon 50.

De préférence, la zone focale est de l'ordre de 100³ µm³ (100µm*100µm*100µm). La dimension de cette zone focale est fixée par la fréquence des ondes acoustiques, la dimension du système de focalisation et la distance focale du système de focalisation.

Le système de focalisation 20 est agencé et dimensionné pour recevoir l'ensemble des ondes acoustiques émises par les générateurs 10 d'ondes acoustiques.

Le système de focalisation 20 est configuré de sorte à présenter une distance focale minimale. Une distance focale minimale permet avantageusement de minimiser le volume de la zone focale, et donc de maximiser les intensités acoustiques atteintes dans la zone focale. Dans un exemple de réalisation, la distance focale est de l'ordre de 10 cm.

Le système de focalisation 20 présente avantageusement une forme adaptée en fonction des vitesses acoustiques de chaque milieu 30, 40 et de sa propre vitesse acoustique.

Dans un exemple de réalisation du système de focalisation 20, ledit système de focalisation est une lentille de focalisation. La lentille de focalisation comporte :
- une première face 21, destinée à être en vis-à-vis des N générateurs 10 d'ondes acoustiques, présentant une forme qui est fonction de la vitesse acoustique du premier milieu 30 et de la vitesse acoustique de la lentille de focalisation,
- une seconde face 22, destinée à être en vis-à-vis de l'échantillon 50, présentant une forme qui est fonction de la vitesse acoustique du second milieu 40 et de la vitesse acoustique de la lentille de focalisation,

Dans cet exemple de réalisation, la dimension de la zone focale est ainsi fixée par la fréquence f des ondes acoustiques, le diamètre de la lentille de focalisation et la distance focale de la lentille de focalisation.

Dans l'exemple illustré sur la figure 1, le système de focalisation 20 est une lentille biconcave. Une lentille biconcave est utilisée lorsque les premier et second milieux présentent tous deux une vitesse acoustique inférieure à la vitesse acoustique du matériau constitutif de la lentille.

Dans une forme de réalisation du dispositif, le système de focalisation 20 est disposé et maintenu fixement dans un cylindre 19. Le barillet 15, comportant les générateurs 10 d'ondes acoustiques, est disposé au niveau d'une première extrémité 191 du cylindre. Une plaque, formant couvercle 18, est disposée au niveau d'une seconde extrémité 192 du cylindre. Le barillet 15 et le système de focalisation 20 sont séparés par le premier milieu 30. Le système de focalisation 20 et le couvercle 18 sont séparés par le second milieu 40.

Dans l'exemple non limitatif de la figure 1, le cylindre 19 est de section circulaire. De préférence, le premier milieu 30 est choisi de sorte à favoriser la propagation des ondes acoustiques émises par les N générateurs 10 d'ondes acoustiques vers le système de focalisation 20. Le premier milieu 30 est préférentiellement un solide ou un liquide.

De préférence, le second milieu 40 est choisi de sorte à favoriser la propagation des ondes acoustiques en sortie du système de focalisation 20 vers l'échantillon 50. Le second milieu 40 est préférentiellement un solide ou un liquide.

Dans une forme de réalisation, les premier et second milieux 30, 40 sont identiques.

Dans un mode préféré de réalisation, non représenté sur les figures, le dispositif 100 comporte un organe de déplacement de la zone focale dans l'échantillon 50. Un tel organe de déplacement permet avantageusement de déplacer la zone focale dans l'échantillon pour faire croitre le diamant.

Dans un exemple de réalisation d'un organe de déplacement, ledit organe de déplacement est configuré pour déplacer l'échantillon 50.

Dans un autre exemple de réalisation d'un organe de déplacement, ledit organe de déplacement est configuré pour déplacer le système de focalisation 20.

Dans un autre exemple de réalisation d'un organe de déplacement, ledit organe de déplacement est configuré pour déplacer les générateurs 10 d'ondes acoustiques.

Dans un autre exemple de réalisation d'un organe de déplacement, ledit organe de déplacement est configuré pour déphaser les générateurs 10 d'ondes acoustiques.

Le procédé pour produire du diamant à partir d'un échantillon comportant un matériau carboné est à présent décrit.

Le procédé comporte la génération et l'émission de N ondes acoustiques. Lesdites N ondes acoustiques sont émises simultanément, avec des intensités prédéterminées, de préférence de même intensité, et pendant des durées prédéterminées, de préférence pendant une même durée.

A titre d'exemple illustratif, les ondes acoustiques sont émises chacune avec une intensité comprise entre 10⁵ et 10⁷ W.m⁻², pendant une durée de l'ordre de l'heure. La génération et l'émission des N ondes acoustiques sont réalisées de préférence via les N générateurs 10 d'ondes acoustiques, contrôlés par l'unité de gestion. La durée de l'émission de chacune des N ondes acoustiques est contrôlée par l'unité de gestion.

Les N ondes acoustiques émises sont focalisées en une zone focale dans l'échantillon 50. Les N ondes acoustiques sont émises en direction du système de focalisation 20, vont traverser ledit système de focalisation et vont converger vers l'échantillon 50.

Selon l'invention, chacune des N ondes acoustiques est émise avec une intensité acoustique minimale pour générer ensemble au niveau de la zone focale une intensité acoustique au moins égale à une intensité acoustique minimale suffisante pour réaliser un changement de phase du matériau carboné en diamant.

Pour parvenir au changement de phase d'un matériau carboné en diamant, par compression, il est connu de l'homme du métier que deux conditions doivent être réunies :
- être à des pressions suffisantes pour que le diamant soit plus stable que le matériau carboné,
- conférer suffisamment d'énergie cinétique aux atomes de carbone du matériau carboné pour rompre la métastabilité dudit matériau carboné induite par les liaisons doubles entre atomes de carbone.

En d'autres termes, une pression suffisante sur le matériau carboné va rendre le diamant stable et une énergie cinétique suffisante va permettre la réalisation du changement de phase.

Pour une compression avec des ondes de choc ou des ondes acoustiques, appelée compression dynamique, la pression et l'énergie cinétique sont apportées par les chocs ou les ondes acoustiques. Ces deux grandeurs peuvent être exprimées comme fonction de l'intensité du choc ou l'intensité acoustique. L'intensité acoustique doit être suffisante pour que :
- la pression atteinte dépasse une pression minimale suffisante rendant le diamant plus stable que le matériau carboné,
- l'énergie cinétique des atomes soit suffisante pour rompre la métastabilité dudit matériau carboné pendant la durée de l'émission des ondes de choc ou des ondes acoustiques.

Lorsque l'intensité acoustique est suffisante, la durée de l'émission de l'intensité acoustique conditionne ensuite la proportion du changement de phase, c'est à dire le pourcentage de conversion du matériau carboné en diamant. En d'autres termes, pour une intensité acoustique émise donnée, le pourcentage de conversion du matériau carboné en diamant est fonction de la durée de l'émission de cette intensité acoustique. Plus précisément, plus la durée de l'émission de l'intensité acoustique est importante, plus le pourcentage de conversion du matériau carboné en diamant augmente. De plus, pour un pourcentage de conversion du matériau carboné en diamant souhaité, plus l'intensité acoustique émise est importante, plus la durée de l'émission de l'intensité acoustique est réduite.

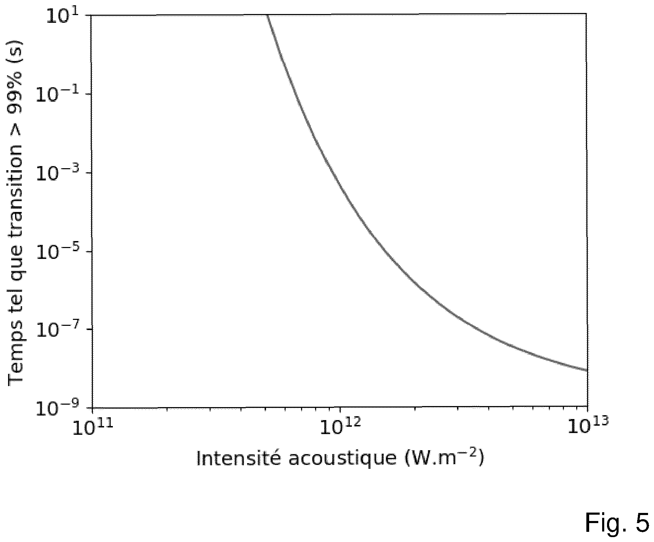

A titre illustratif, la figure 5 représente un graphique illustrant la durée nécessaire de l'émission d'une onde acoustique en fonction de l'intensité de ladite onde acoustique pour recréer les conditions suffisantes pour parvenir à un changement de phase de 99% d'un échantillon de graphite en diamant, pour la technologie de l'onde de choc par explosion. Cette courbe a été calculée en extrapolant avec la loi d'Arrhenius des mesures expérimentales faites avec des ondes de choc d'intensité de l'ordre de 10¹² W.m⁻² et 10¹³ W.m⁻².

Ainsi comme le montre la figure 5, une intensité acoustique, de l'ordre de 10¹³ W.m⁻² permettant d'atteindre une pression de 20 GPa, pression supérieure à la pression minimale suffisante pour que le diamant soit stable, confère aux atomes de carbone une énergie cinétique telle qu'au moins 99% de l'échantillon en graphite sera converti en diamant en une durée de l'ordre de 10 ns. Une intensité acoustique de l'ordre de 10¹² W.m⁻², permettant, quant à elle, d'atteindre une pression de 6 GPa, pression supérieure à la pression minimale suffisante pour que le diamant soit stable, confère aux atomes de carbone une énergie cinétique telle qu'au moins 99% de l'échantillon en graphite sera converti en diamant en une durée de l'ordre de 1 ms. Par contre, une intensité acoustique inférieure à 5.10¹¹ W.m⁻² induira un changement de phase en une durée supérieure à la centaine d'heures à condition que la pression soit toujours suffisante pour être dans le régime de stabilité du diamant.

En revenant à l'invention, chaque onde acoustique, générée par un générateur 10, est émise avec une intensité acoustique donnée. Chaque onde acoustique, générée par un générateur 10, et qui se propage vers la zone focale, génère ainsi une pression acoustique et une énergie cinétique au niveau des atomes de carbone du matériau carboné de l'échantillon 50 situé dans la zone focale.

Ainsi, au niveau de la zone focale, donc dans un volume très réduit, l'ensemble des ondes acoustiques vont former une onde acoustique unique, avec une intensité acoustique, dite globale, formée par l'ensemble des intensités acoustiques des N ondes acoustiques. Cette intensité acoustique globale, au niveau de la zone focale, pourra être très supérieure à l'intensité acoustique de chaque onde acoustique générée par un générateur 10. Par exemple, si toutes les ondes acoustiques ont la même fréquence et sont en phase, l'intensité acoustique au niveau de la zone focale peut être supérieure de l'ordre d'un facteur 1000 fois N. Ce facteur se détermine par le carré du rapport du diamètre de l'élément piézoélectrique du générateur d'ondes acoustiques sur le diamètre de la zone focale.

L'ensemble des ondes acoustiques vont ainsi générer ensemble, au niveau de la zone focale, une pression acoustique et une énergie cinétique. La pression acoustique et l'énergie cinétique seront fonction de l'intensité acoustique globale. Pour que le changement de phase du matériau carboné en diamant ait lieu dans la zone focale, il est nécessaire, qu'au niveau de la zone focale, l'intensité acoustique générée soit au moins égale à l'intensité acoustique minimale suffisante.

L'homme du métier est parfaitement à même de déterminer l'intensité acoustique minimale, au niveau de la zone focale, pour recréer les conditions suffisantes (pression, énergie cinétique) pour permettre ce changement de phase du matériau carboné en diamant.

Connaissant l'intensité acoustique minimale de l'onde acoustique, au niveau de la zone focale, il est possible de déduire l'intensité acoustique minimale nécessaire à générer par chacun des générateurs d'ondes acoustiques.

Dans un exemple de mise en œuvre, l'intensité acoustique de l'onde acoustique, au niveau de la zone focale, peut être augmentée en augmentant le nombre de générateurs d'ondes acoustiques.

Dans un autre exemple de mise en œuvre, l'intensité acoustique de l'onde acoustique, au niveau de la zone focale, peut être augmentée en augmentant la puissance acoustique, donc l'intensité acoustique, de chaque générateur d'ondes acoustiques. L'augmentation d'intensité acoustique d'un générateur d'ondes acoustiques peut être obtenue par une augmentation de la tension aux bornes dudit générateur d'ondes acoustiques. L'augmentation de l'intensité acoustique d'un générateur d'ondes acoustiques, lorsque ledit générateur d'ondes acoustiques est un actionneur piézoélectrique, peut également être obtenue par une augmentation du nombre d'éléments piézoélectriques par actionneur piézoélectrique.

Comme décrit précédemment, lorsque l'intensité acoustique obtenue au niveau de la zone focale est suffisante pour réaliser un changement de phase du matériau carboné en diamant, la durée de l'émission de ladite intensité acoustique va conditionner la proportion du changement de phase du matériau carboné en diamant dans la zone focale. En d'autres termes, pour une intensité acoustique donnée au niveau de la zone focale, le pourcentage de conversion du matériau carboné en diamant, dans la zone focale, est fonction de la durée de l'émission des N ondes acoustiques. Plus précisément, pour une intensité acoustique donnée, le pourcentage de conversion du matériau carboné en diamant augmente avec la durée de l'émission des N ondes acoustiques.

Le procédé selon l'invention permet ainsi avantageusement de créer un germe de diamant, ou d'agrandir un germe préalablement présent dans l'échantillon, au niveau de la zone focale. Le procédé permet avantageusement de contrôler finement la localisation spatiale où les conditions sont réunies pour permettre la formation du diamant. Le procédé selon l'invention permet également avantageusement de produire du diamant, sans détruire l'échantillon, contrairement aux technologies d'ondes de choc.

Le procédé selon l'invention permet aussi de contrôler la durée de l'émission des N ondes acoustiques.

Dans un mode particulier de mise en œuvre du procédé, pendant l'émission des N ondes acoustiques, la zone focale est déplacée dans l'échantillon.

Ce mode particulier du procédé est mis en œuvre lorsque les N ondes acoustiques sont émises pendant une durée supérieure à la durée d'émission nécessaire pour convertir un pourcentage prédéfini souhaité du matériau carboné en diamant dans la zone focale.

Le déplacement de la zone focale dans l'échantillon permet avantageusement de faire croitre le germe de diamant jusqu'à l'obtention d'une dimension et d'une forme souhaitée pour le diamant. Le sens du déplacement de la zone focale dans l'échantillon permet de diriger le sens de croissance du diamant pour obtenir la forme souhaitée.

La vitesse de déplacement de la zone focale dans l'échantillon est avantageusement liée à la durée de l'émission des N ondes acoustiques nécessaire pour convertir un pourcentage prédéfini souhaité du matériau carboné en diamant dans la zone focale. Donc la vitesse de déplacement de la zone focale dans l'échantillon est fonction de l'intensité acoustique de l'onde acoustique dans la zone focale, car l'intensité acoustique détermine la durée de l'émission nécessaire pour permettre la conversion du pourcentage prédéfini souhaité du matériau carboné en diamant.

De préférence, vu que la durée de l'émission nécessaire pour permettre la conversion de tout ou partie du matériau carboné en diamant, est très courte, généralement inférieure à la seconde, le déplacement de la zone focale peut être réalisé de manière continue, en adaptant la vitesse de déplacement de la zone focale.

Dans un exemple de mise en œuvre, pour obtenir un déplacement relatif de la zone focale par rapport à l'échantillon, l'échantillon est déplacé par un organe de déplacement.

Dans un autre exemple de mise en œuvre, pour obtenir un déplacement relatif de la zone focale par rapport à l'échantillon, le système de focalisation est déplacé par un organe de déplacement.

Dans un autre exemple de mise en œuvre, pour obtenir un déplacement relatif de la zone focale par rapport à l'échantillon, les générateurs d'ondes acoustiques sont déplacés simultanément par un organe de déplacement.

Dans un autre exemple de mise en œuvre, pour obtenir un déplacement relatif de la zone focale par rapport à l'échantillon, les générateurs d'ondes acoustiques sont déphasés les uns par rapport aux autres avec des valeurs bien déterminées pour obtenir le déplacement de la zone focale dans l'échantillon.

La description ci-avant illustre clairement que par ses différentes caractéristiques et leurs avantages, la présente invention atteint les objectifs qu'elle s'était fixés. En particulier, elle fournit un procédé pour produire du diamant qui présente l'avantage de ne pas détruire l'échantillon, contrairement aux technologies existantes recourant aux ondes de choc, et de maitriser finement la direction de croissance du diamant, contrairement aux technologies HPHT et CVD.

## Revendications

1. Procédé pour produire du diamant à partir d'un échantillon comportant un matériau carboné, comportant la génération et l'émission de N ondes acoustiques, N étant un nombre supérieur ou égal à 2, lesdites N ondes acoustiques émises étant focalisées en une zone focale dans l'échantillon (50),
chacune des N ondes acoustiques étant émise avec une intensité acoustique minimale pour générer ensemble au niveau de la zone focale une intensité acoustique au moins égale à une intensité acoustique minimale suffisante pour réaliser un changement de phase du matériau carboné en diamant.

2. Procédé selon la revendication 1 comportant, pendant l'émission des N ondes acoustiques, le déplacement de la zone focale dans l'échantillon (50).

3. Dispositif (100) pour la mise en œuvre du procédé selon l'une des revendications précédentes comportant :
- N générateurs (10) d'ondes acoustiques, configurés pour générer chacun une onde acoustique, N étant un nombre supérieur ou égal à 2,
- un système de focalisation (20) des ondes acoustiques en une zone focale dans l'échantillon (50)

4. Dispositif (100) selon la revendication 3 dans lequel chaque générateur (10) d'ondes acoustiques est un actionneur piézoélectrique.

5. Dispositif (100) selon l'une des revendications 3 ou 4 comportant un organe de déplacement de la zone focale dans l'échantillon (50).

6. Dispositif (100) selon la revendication précédente dans lequel l'organe de déplacement de la zone focale dans l'échantillon (50) est un organe de déplacement du système de focalisation des ondes acoustiques et/ou un organe de déplacement de l'échantillon et/ou un organe de déplacement des générateurs d'ondes acoustiques et/ou un organe de déphasage des générateurs d'ondes acoustiques.
